# EUROPÄISCHE PATENTSCHRIFT

(11) **EP 0 562 243 B1**
(45) Veröffentlichungstag und Bekanntmachung des Hinweises auf die Patenterteilung: **10.05.1995**
(21) Anmeldenummer: 93101688.5
(22) Anmeldetag: 04.02.1993
(51) Int. Cl.: H05K 3/34, B23K 3/06, B23K 3/08, H05K 13/00

(54) **Lotschwallschutzschienen für Leiterplatten**
Solder wave-protecting rails for printed circuits
Rails protégeant les plaquettes de circuits imprimés contre les vagues de soudure

(30) Priorität: 25.03.1992 DE 9204205 U
(43) Veröffentlichungstag der Anmeldung: 29.09.1993
(73) Patentinhaber: DETEWE - DEUTSCHE TELEPHONWERKE Aktiengesellschaft & Co., 10997 Berlin (DE)
(72) Erfinder: Bell, Hans, W-1100 Berlin (DE); Exner, Raimund, W-1092 Berlin (DE)

(56) Entgegenhaltungen:
- EP-A- 0 365 418
- US-A- 3 671 919

## Beschreibung

Die Erfindung betrifft Schwallschutzschienen für Leiterplatten, die die Kopplung der Leiterplatten untereinander beim Durchlauf durch Lötmaschinen ohne zusätzliche Hilfsmittel gestatten.

Beim Wellenlöten von Leiterplatten werden Hilfswerkzeuge verwendet, die verhindern, daß beim Lötvorgang Lot auf die Oberseite der Leiterplatte gelangt. Diese Hilfswerkzeug sind als Schwallschutz oder Bugschutz bekannt, leicht montierbar und wiederverwendbar. Um die Kapazität von Wellenlötanlagen zu erhöhen, werden mehrere Leiterplatten in einem Lötrahmen befestigt und dieser mittels z. B. Kettenfördereinrichtungen durch die Lötmaschine bewegt. Beim Wellenlöten werden die Leiterplatten in einer ansteigenden schrägen Förderebene mit einem Winkel von typisch bis zu 12° bewegt und danach auf einer im Winkel abfallenden Transporteinrichtung der weiteren Bearbeitung zugeführt (DE-30 39 075 A1). Dabei sind beim Übergang von der horizontalen zur steigenden und fallenden Förderung Stellen zu überwinden, an denen die Rahmen im Winkel der Förderebenen zueinander bewegt werden (Knickstellen).

Um die Kapazitätsauslastung von Wellenlötanlagen zu erhöhen, bietet es sich an, die Leiterplatten ohne Einspannung in einen Rahmen unmittelbar über das Lötbad zu führen. Für diesen Fall muß die Verbindung der Leiterplatten untereinander beim Überwinden der Stellen, an denen die verschiedenen Förderebenen aufeinander treffen, gesichert sein.

Der Erfindung lag die Aufgabe zugrunde, die Möglichkeit der Aneinanderreihung von Leiterplatten durch einfache Hilfswerkzeuge zu schaffen, die einen sicheren Zusammenhalt der Leiterplatten beim Passieren von Stoßstellen winklig zueinander stehender Förderebenen gewährleisten.

Diese Aufgabe ist durch die Erfindung gelöst, wie sie im Kennzeichnungsteil des ersten Schutzanspruches dargelegt ist.

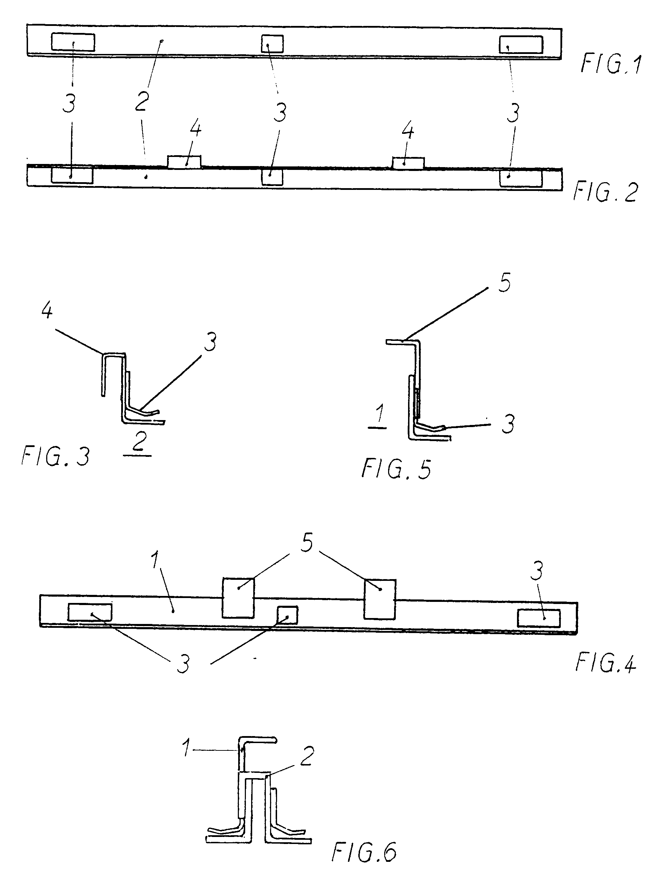

Anhand einer aus sechs Figuren bestehenden Zeichnung wird die Erfindung nachfolgend näher erläutert. Darin zeigt die
- Fig. 1: eine hintere Schwallschutzschiene in der Ansicht, die
- Fig. 2: die hintere Schwallschutzschiene in der Aufsicht, die
- Fig. 3: die hintere Schwallschutzschiene in einer vergrößerten Seitensicht, die
- Fig. 4: die vordere Schwallschutzschiene in der Ansicht, die
- Fig. 5: die vordere Schwallschutzschiene in einer vergrößerten Seitensicht und die
- Fig. 6: die gekoppelte hintere und vordere Schwallschutzschiene in einer vergrößerten Seitensicht.

In allen Figuren tragen gleiche Teile dieselben Bezugszeichen.

Als Schwallschutzschienen werden je Leiterplatte, bezüglich der Transportrichtung durch die Lötmaschine betrachtet, eine vordere Schwallschutzschiene 1 und eine hintere Schwallschutzschiene 2 eingesetzt. Die Schwallschutzschienen 1, 2 weisen einen L-förmigen Querschnitt auf. Am längeren, in der Gebrauchslage senkrecht stehenden Schenkel der L-förmigen Schwallschutzschienen 1, 2 sind Federn 3 angebracht. Zwischen diesen Federn 3 und dem kürzeren Schenkel der Schwallschutzschienen 1, 2 wird eine Leiterplatte durch Klemmwirkung gehalten.

Die hintere Schwallschutzschiene 2 trägt mindestens zwei Haken 4, die ein Einhängen in die vordere Schwallschutzschiene 1 der nachfolgenden Leiterplatte gestatten. An der vorderen Schwallschutzschiene 1 sind mindestens zwei L-förmige Gegenhalter 5 angeordnet. Die Haken 4 und die Gegenhalter 5 sind im gezeigten Beispiel derart an den Schwallschutzschienen 1 bzw. 2 angebracht, daß nach dem Einhängen der hinteren 2 in die vordere 1 Schwallschutzschiene die Gegenhalter 5 zwischen den Haken 4 liegen. Eine andere Ausführung sieht den entgegengesetzten Fall vor, bei dem die Haken zwischen den Gegenhaltern 5 liegen. Haken 4 und Gegenhalter 5 können zudem derart angeordnet werden, daß nur ein minimales seitliches Spiel beim Transport der Leiterplatte möglich ist.

Die Haken 4 sind derart gestaltet, daß sie eine freie, voneinander unabhängige Kippbewegung der Leiterplatten gestatten. Die Gegenhalter 5 verhindern beim Transport über Stoßpunkte verschiedener Förderebenen (Knickstellen) ein Aushängen der gekoppelten Leiterplatte.

Durch Verwendung der vorgeschlagenen Schwallschutzschienen wird, bedingt durch die enge Kopplung der Leiterplatten hintereinander, ein größerer Durchsatz durch die Wellenlötanlage erzielt.

## Patentansprüche

1. Schwallschutzschienen für eine Leiterplatte zum Verhindern, daß beim Lötvorgang Lot auf die Oberseite der Leiterplatte gelangt und die die Kopplung der Leiterplatte mit einer nachfolgenden Leiterplatte beim Durchlauf durch Lötmaschinen ohne zusätzliche Hilfsmittel gestatten, dadurch gekennzeichnet, daß eine vordere und eine hintere, L-förmige Schwallschutzschiene (1, 2) vorgesehen sind, die mit Federn (3) zum Verklemmen der Leiterplatte in horizontaler Lage auf den kürzeren Schenkeln versehen sind und daß der in der Gebrauchslage senkrechte, längere Schenkel der in Transportrichtung betrachtet hinteren Schwallschutzschiene (2) mit Haken (4) und der der vorderen Schwallschutzschiene (1) mit Gegenhaltern (5) bestückt ist, so daß die Haken der hintere Schwallschutzschiene (2) in den längeren Schenkel der vorderen Schwallschutzschiene (1) der folgenden Leiterplatte einhängbar sind und durch die Gegenhalter (5) ein Aushängen beim Transport über Stoßpunkte verschiedener Förderebenen verhindert ist.

2. Schwallschutzschienen nach Anspruch 1, dadurch gekennzeichnet, daß die vorderen Schwallschutzschienen (1) mindestens zwei Gegenhalter (5) und die hinteren Schwallschutzschienen (2) mindestens zwei Haken (4) tragen.

3. Schwallschutzschienen nach Anspruch 1 und 2, dadurch gekennzeichnet, daß die Haken (4) in der Gebrauchslage zwischen den Gegenhaltern (5) liegen.

4. Schwallschutzschienen nach Anspruch 1 und 2, dadurch gekennzeichnet, daß die Gegenhalter (5) in der Gebrauchslage zwischen den Haken (4) liegen.

## Claims

1. Splash-proof rails for a printed circuit board for preventing solder from reaching the upper side of the printed circuit board during the soldering process, which rails permit the coupling of the printed circuit board with a following printed circuit board, during passage through soldering machines, without additional aids, characterised in that a front and a rear L-shaped splash-proof rail (1, 2) are provided, which rails are provided with springs (3) for clamping the printed circuit board in the horizontal position on the shorter legs, and in that the longer leg, which is vertical in the position of normal use, of that splash-proof rail (2), which, viewed in the direction of transportation, is the rear rail, is fitted with hooks (4) and the longer leg of the front splash-proof rail (1) is fitted with counter-holders (5) so that the hooks of the rear splash-proof rail (2) can be hooked into the longer leg of the front splash-proof rail (1) of the following printed circuit board and during transportation over points of impact of various conveying planes unhooking is prevented by means of the counter-holders (5).

2. Splash-proof rails according to claim 1, characterised in that the front splash-proof rails (1) bear at least two counter-holders (5) and the rear splash-proof rails (2) bear at least two hooks (4).

3. Splash-proof rails according to claim 1 and 2, characterised in that in the position of normal use the hooks (4) lie between the counter-holders (5).

4. Splash-proof rails according to claim 1 and 2, characterised in that in the position of normal use the counter-holders (5) lie between the hooks (4).

## Revendications

1. Rails de protection contre les vagues pour une plaquette à circuit imprimé, destinés à empêcher que de la soudure parvienne sur la face supérieure de la plaquette à circuit imprimé lors de l'opération de soudage et permettant de coupler sans moyen supplémentaire la plaquette à circuit imprimé avec une plaquette à circuit imprimé placée à la suite lors du passage dans la machine à souder, caractérisés par le fait qu'un rail de protection avant et un rail de protection arrière (1, 2) en forme de L sont pourvus de ressorts (3) destinés à bloquer la plaquette à circuit imprimé en position horizontale sur les ailes les plus courtes et par le fait que l'aile plus longue, verticale en position d'utilisation, du rail de protection (2) arrière, vu dans la direction de transport, est équipée de crochets (4) et l'aile du rail de protection (1) avant porte dex contre-appuis (5), de telle sorte que les crochets du rail de protection (2) arrière peuvent être accrochés sur l'aile plus longue du rail de protection (1) avant de la plaquette à circuit imprimé suivante et que les contre-appuis (5) empêchent un décrochement lors du passage sur des raccords entre plans de transport différents.

2. Rails de protection contre les vagues selon la revendication 1, caractérisés par le fait que les rails de protection (1) avant comportent au moins deux contre-appuis (5) et les rails de protection (2) arrière au moins deux crochets (4).

3. Rail de protection contre les vagues selon les revendications 1 et 2, caractérisé par le fait qu'en position d'utilisation, les crochets (4) sont situés entre les contre-appuis (5).

4. Rail de protection contre les vagues selon les revendications 1 et 2, caractérisé par le fait qu'en position d'utilisation, les contre appuis (5) sont situés entre les crochets (4).
